# DEMANDE DE BREVET EUROPEEN

(11) **EP 2 408 268 A1**
(43) Date de publication de la demande: **18.01.2012**
(21) Numéro de dépôt: 11185303.2
(22) Date de dépôt: 16.11.2007
(51) Int. Cl.: H05B 33/26, C03C 17/36, H01L 51/52, G02F 1/1343, H01J 1/30

(54) **Electrode pour dispositif electroluminescent organique, sa gravure acide, ainsi que dispositif electroluminescent organique l'incorporant**

(30) Priorité: 17.11.2006 FR 0654952
(62) Demande divisionnaire de: 07858713.6
(71) Demandeur: Saint-Gobain Glass France, 92400 Courbevoie (FR)
(72) Inventeur: Tchakarov, Svetoslav, 92330 SCEAUX (FR); Reutler, Pascal, 75019 PARIS (FR)
(74) Mandataire: Lucas, Francois

(57) **Abrégé**

La présente invention a pour objet une électrode multicouche (3), sa gravure acide ainsi que des dispositifs électroluminescents organiques l'incorporant. L'électrode multicouche, dite inférieure comportant successivement :
- une couche de contact (31) à base d'oxyde métallique et/ou de nitrure métallique,
- une couche fonctionnelle métallique (32) à propriétés intrinsèques de conductivité électrique, à base d'un matériau pur qui est de l'argent, ou à base dudit matériau allié ou dopé
- une fine couche de blocage (32') directement sur la couche fonctionnelle, la couche comprenant une couche métallique d'épaisseur inférieure ou égale à 5 nm et/ou une couche avec une épaisseur inférieure ou égale à 10 nm, qui est à base d'oxyde métallique sous stoechiométrique, d'oxynitrure métallique sous stoechiométrique ou de nitrure métallique sous stoechiométrique,
- un revêtement comportant une surcouche à base d'oxyde métallique (34), d'adaptation du travail de sortie, la surcouche étant la dernière couche.

## Description

La présente invention a pour objet une électrode multicouches pour dispositif électroluminescent organique, sa gravure acide ainsi qu'un dispositif électroluminescents organique l'incorporant.

Les systèmes électroluminescents organiques connus ou OLED (pour « Organic Light Emitting Diodes » en anglais) comportent un matériau ou un empilement de matériaux électroluminescents organiques alimenté en électricité par des électrodes généralement sous forme de deux couches électroconductrices l'encadrant.

Ces couches électroconductrices comportent communément une couche à base d'oxyde d'indium, généralement l'oxyde d'indium dopé à l'étain plus connu sous l'abréviation ITO. Les couches ITO ont été particulièrement étudiées. Elles peuvent être aisément déposées par pulvérisation cathodique assistée par champ magnétique, soit à partir d'une cible d'oxyde (pulvérisation non réactive), soit à partir d'une cible à base d'indium et d'étain (pulvérisation réactive en présence d'un agent oxydant du type oxygène) épaisse de l'ordre de 100 à 150 nm. Cependant, cette couche d'ITO présente un certain nombre d'inconvénients. En premier lieu, la matière et le procédé de dépôt à température élevée (350°C) pour améliorer la conductivité engendrent des surcoûts. La résistance carré reste relativement élevée (de l'ordre de 10 Ω/carré) à moins d'augmenter l'épaisseur des couches au-delà de 150 nm ce qui résulte en une diminution de la transparence et en une augmentation de la rugosité de surface.

Aussi, de nouvelles structures d'électrode se développent. On connaît par exemple par le document JP2005-038642 un écran plat électroluminescent TFT (« thin-film transistor » en anglais) comportant des systèmes électroluminescents organiques à émission par le haut (« top emission » en anglais) générant respectivement, une lumière rouge, une lumière verte, et une lumière bleue, pour former une matrice active.

Chaque dispositif organique électroluminescent est pourvu d'une électrode dite inférieure ou arrière (ou « bottom electrode » en anglais), comportant :
- une couche de contact, par exemple en ITO,
- une couche métallique (semi)réfléchissante notamment à base d'argent, d'aluminium, ou en argent contenant de l'aluminium, d'épaisseur au moins égale à 50 nm,
- une surcouche d'adaptation du travail de sortie, par exemple en ITO.

Le but que se fixe l'invention est de parvenir à obtenir un assemblage de couches électroconductrices pour former une électrode fiable, robuste (notamment en termes de stabilité et/ou de tenue mécanique, thermique) sans sacrifier ses propriétés d'électroconductivité, sa qualité optique, ni les performances du dispositif l'incorporant, ni engendrer des difficultés de réalisation.

Le but que se fixe l'invention est en particulier de parvenir à obtenir un assemblage de couches électroconductrices pour former une électrode inférieure d'un système électroluminescent fiable, robuste sans sacrifier ses propriétés d'électroconductivité, sa qualité optique, ni les performances optiques de l'OLED, ni engendrer des difficultés de réalisation.

Par électrode inférieure au sens de l'invention il faut comprendre que l'on fait référence à l'électrode la plus proche du substrat, intercalée entre le substrat porteur et le système OLED.

Accessoirement, il s'agit d'atteindre cet objectif sans bouleverser les configurations connues des systèmes électroluminescents organiques concernant l'invention, et à moindre coût.

Il s'agit de mettre au point des électrodes essentiellement transparentes, semi transparentes (à la fois transparentes et réfléchissantes) ou réfléchissantes qui conviennent aussi bien pour des OLEDS formant des écrans OLED à matrice active et aussi passive, ou utilisés dans des applications d'éclairage général (architectural et/ou décoratif) ou de signalétique voire même pour d'autres applications électroniques.

A cet effet, l'invention a pour objet un substrat, pour dispositif électroluminescent organique, porteur sur une première face principale d'une électrode multicouche dite inférieure, laquelle comporte successivement :
- une couche, dite de contact, en matériau diélectrique de type oxyde métallique et/ou de nitrure métallique,
- une couche fonctionnelle métallique à propriétés intrinsèques de conductivité électrique,
- une fine couche de blocage directement sur la couche fonctionnelle métallique, la fine couche de blocage comprenant une couche métallique d'épaisseur inférieure ou égale à 5 nm, préférentiellement comprise entre 0,5 et 2 nm, et/ou comprenant une couche avec une épaisseur inférieure ou égale à 10 nm, préférentiellement comprise entre 0,5 et 2 nm, et qui est à base d'oxyde métallique sous stoechiométrique, d'oxynitrure métallique sous stoechiométrique ou de nitrure métallique sous stoechiométrique,
- un revêtement comportant une surcouche, en matériau diélectrique à base d'oxyde métallique, formant une couche d'adaptation du travail de sortie.

La fine couche de blocage forme une couche de protection voire même une couche « sacrificielle » qui permet d'éviter l'altération du métal fonctionnel, notamment pur et/ou en couche mince, dans l'une et/ou l'autre des configurations suivantes :
- si la couche qui surmonte la couche fonctionnelle est déposée en utilisant un plasma réactif (oxygène, azote ...), par exemple si la couche d'oxyde qui la surmonte est déposée par pulvérisation cathodique,
- si la composition de la couche qui surmonte la couche fonctionnelle est susceptible de varier lors de la fabrication industrielle (évolution conditions de dépôt type usure d'une cible etc) notamment si la stoechiométrie d'une couche de type oxyde et/ou nitrure évolue, modifiant alors la qualité de la couche fonctionnelle et donc les propriétés de l'électrode (résistance carré, transmission lumineuse...),
- si l'électrode subit postérieurement au dépôt un traitement thermique.

Cette couche protectrice voire sacrificielle améliore significativement la reproductibilité des propriétés électriques et optiques de l'électrode. Cela est très important pour une démarche industrielle ou une seule faible dispersion des propriétés des électrodes est acceptable.

La fine couche blocage choisie métallique peut être, de préférence, constituée d'un matériau choisi parmi l'un au moins des métaux suivants Ti, V, Mn, Fe, Co, Cu, Zn, Zr, Hf, Al, Nb, Ni, Cr, Mo, Ta, W, ou d'un alliage à base d'au moins un de ces matériaux.

On préfère en particulier une fine couche de blocage à base d'un métal choisi parmi le niobium Nb, le tantale Ta, le titane Ti, le chrome Cr ou le nickel Ni ou d'un alliage à partir d'au moins deux de ces métaux, notamment d'un alliage de niobium et de tantale (Nb/Ta), de niobium et de chrome (Nb/Cr) ou de tantale et de chrome (Ta/Cr) ou de nickel et de chrome (Ni/Cr). Ce type de couche à base d'au moins un métal présente un effet de piégeage (effet « getter ») particulièrement important.

Une fine couche de blocage métallique peut être aisément fabriquée sans altérer la couche fonctionnelle. Cette couche métallique peut être de préférence déposée dans une atmosphère inerte (c'est-à-dire sans introduction volontaire d'oxygène ou d'azote) constituée de gaz noble (He, Ne, Xe, Ar, Kr). Il n'est pas exclu ni gênant qu'en surface cette couche métallique soit oxydée lors du dépôt ultérieur d'une couche à base d'oxyde métallique.

La telle fine couche de blocage métallique permet en outre d'obtenir une excellente tenue mécanique (résistance à l'abrasion, aux rayures notamment). Ceci est spécialement vrai pour des empilements qui subissent un traitement thermique, et donc une diffusion important d'oxygène ou d'azote.

Néanmoins, pour l'utilisation de couche de blocage métallique, il faut limiter l'épaisseur de la couche métallique et donc l'absorption lumineuse pour conserver une transmission lumineuse suffisante.

La fine couche de blocage peut être partiellement oxydée. Cette couche est déposée sous forme non métallique et n'est donc pas déposée sous forme stoechiométrique, mais sous forme sous-stoechiométrique, du type MOₓ, où M représente le matériau et x est un nombre inférieur à la stoechiométrie de l'oxyde du matériau ou du type MNOx pour un oxyde de deux matériaux M et N (ou plus). On peut citer par exemple TiOx, NiCrOx.

X est de préférence compris entre 0,75 fois et 0,99 fois la stoechiométrie normale de l'oxyde. Pour un monoxyde, on peut notamment choisir x entre 0,5 et 0,98 et pour un dioxyde x entre 1,5 et 1,98.

Dans une variante particulière, la fine couche de blocage est à base de TiOₓ et x peut être en particulier tel que 1,5 ≤ x ≤ 1,98 ou 1,5 < x < 1,7, voire 1,7 ≤ x ≤ 1,95.

La fine couche de blocage peut être partiellement nitrurée. Elle n'est donc pas déposée sous forme stoechiométrique, mais sous forme sous-stoechiométrique, du type MN_{y}, où M représente le matériau et y est un nombre inférieur à la stoechiométrie de du nitrure du matériau. Y est de préférence compris entre 0,75 fois et 0,99 fois la stoechiométrie normale du nitrure.

De la même manière, la fine couche de blocage peut aussi être partiellement oxynitrurée.

Cette fine couche de blocage oxydée et/ou nitrurée peut être aisément fabriquée sans altérer la couche fonctionnelle. Elle est, de préférence, déposée à partir d'une cible céramique, dans une atmosphère non oxydante constituée de préférence de gaz noble (He, Ne, Xe, Ar, Kr).

La fine couche de blocage peut être préférentiellement en nitrure et/ou oxyde sous-stoechiométrique pour encore davantage de reproductibilité des propriétés électriques et optiques de l'électrode.

La fine couche blocage choisie oxyde et/ou nitrure sous stoechiométrique peut être, de préférence à base d'un métal choisi parmi l'un au moins des métaux suivants : Ti, V, Mn, Fe, Co, Cu, Zn, Zr, Hf, Al, Nb, Ni, Cr, Mo, Ta, W, ou d'un oxyde d'un alliage sous stoechiométrique à base d'au moins un de ces matériaux.

On préfère en particulier une couche à base d'un oxyde ou d'oxynitrure d'un métal choisi parmi le niobium Nb, le tantale Ta, le titane Ti, le chrome Cr ou le nickel Ni ou d'un alliage à partir d'au moins deux de ces métaux, notamment d'un alliage de niobium et de tantale (Nb/Ta), de niobium et de chrome (Nb/Cr) ou de tantale et de chrome (Ta/Cr) ou de nickel et de chrome (Ni/ Cr).

Comme nitrure métallique sous stoechiométrique, on peut choisir aussi une couche en nitrure de silicium SiNₓ ou d'aluminium AlNx ou de chrome Cr Nx , ou de titane TiNx ou de nitrure de plusieurs métaux comme le NiCrNx.

La fine couche de blocage peut présenter un gradient d'oxydation, par exemple M(N)Oxᵢ avec xᵢ variable, la partie de la couche de blocage en contact avec la couche fonctionnelle est moins oxydée que la partie de cette couche la plus éloignée de la couche fonctionnelle en utilisant une atmosphère de dépôt particulière.

La fine couche de blocage peut aussi être multicouche et notamment comprendre :
- d'une part d'une couche « d'interface » immédiatement en contact avec ladite couche fonctionnelle, cette couche d'interface étant en un matériau à base d'oxyde, de nitrure ou d'oxynitrure métallique non stoechiométrique, tels que ceux précités,
- d'autre part, d'au moins une couche en un matériau métallique, tels que ceux précités, couche immédiatement en contact avec ladite couche « d'interface ».

La couche d'interface peut être un oxyde, un nitrure ou un oxynitrure d'un métal ou de métaux qui est ou sont présent(s) dans la couche métallique adjacente éventuelle.

L'électrode selon l'invention présente une compatibilité des propriétés de surface notamment avec les systèmes électroluminescents organiques tout en ayant des propriétés de conductivité électrique et/ou de transparence ou de réflectivité ajustables à façon, notamment en jouant notamment sur l'épaisseur de la couche fonctionnelle métallique, voire des autres couches et/ou sur les conditions de dépôt.

Pour une structure organique donnée d'un dispositif OLED, l'électrode de l'invention permet d'améliorer le rendement en lm/W de l'OLED d'au moins 5 à 10% pour une brillance supérieure à 500 cd/m² par rapport à une électrode en ITO.

L'électrode selon l'invention peut être sur une grande surface par exemple une surface supérieure ou égale à 0,02 m², voire même 0,5 m² ou 1 m².

De préférence, le revêtement peut avoir une épaisseur supérieure ou égale à 20 nm pour fournir une barrière à l'oxygène et/ou à l'eau et être une monocouche ou une multicouche d'oxyde métallique simple ou mixte dopé ou non, plutôt qu'une couche nitrurée plus absorbante et/ou isolante.

On choisit de préférence une surcouche avec une conductivité électrique supérieure à 10⁻⁶ S.cm⁻¹, voire 10⁻⁴ S.cm⁻¹, couche facile et/ou rapide à réaliser, transparente et économique.

La surcouche peut être de préférence à base de l'un au moins des oxydes métalliques conducteurs et transparents suivants :
- oxyde d'indium, oxyde de zinc, oxyde d'étain, et leurs oxydes mixtes, notamment d'un oxyde mixte de zinc et d'étain SnₓZn_{y}O_{z} généralement non stoechiométrique et sous phase amorphe, ou d'un oxyde mixte d'indium et d'étain (ITO), d'un oxyde mixte d'indium et de zinc (IZO).

Ce type d'oxyde métallique peut être dopé typiquement, entre 0,5 et 5 %. Il s'agit en particulier d'oxyde d'étain dopé par S, ou d'oxyde de zinc dopé par Al (AZO), Ga (GZO), B, Sc, ou Sb pour une meilleure stabilité du procédé de dépôt, et/ou augmenter encore la conductivité électrique,.

Ces oxydes métalliques conducteurs et transparents peuvent être sur stoechiométriques en surface pour augmenter le travail de sortie.

Le revêtement peut être uniquement constitué de cette surcouche par exemple d'épaisseur supérieure ou égale à 15 nm, par exemple comprise entre 20 et 150 nm, pour fournir en même temps la barrière à l'oxygène et/ou à l'eau.

Cette surcouche pouvant être de préférence la dernière couche, on préfère tout particulièrement une surcouche d'ITO qui est stable et permet qui plus est de conserver les technologies existantes pour la fabrication et l'optimisation de la structure organique OLED.

Pour des raisons économiques, si l'on choisit une surcouche en ITO, il est préférable que cette dernière soit d'épaisseur inférieure ou égale à 30 nm, notamment et comprise entre 3 nm et 20 nm et de rajouter une couche additionnelle sous jacente de protection contre l'oxygène pour une épaisseur totale cumulée de préférence supérieure ou égale à 15 nm, à 30 nm, par exemple comprise entre 30 et 150 nm.

La surcouche peut être alternativement ou cumulativement à base de l'un au moins des oxydes métalliques sous stoechiométriques suivants : en oxyde de molybdène oxyde de nickel, oxyde d'aluminium, oxyde de titane, oxyde de zirconium, oxyde de tantale, oxyde de silicium, oxyde d'argent, d'or, de platine, de palladium, et être de préférence d'épaisseur inférieure ou égale à 10 nm, par exemple comprise entre 1 et 5 nm.

Ces oxydes métalliques sont choisis sous stoechiométriques pour être suffisamment électroconducteurs, et fins pour être suffisamment transparents.

On peut déposer la surcouche par une technique de dépôt sous vide, notamment par évaporation ou pulvérisation cathodique assistée par champ magnétique, en particulier à température ambiante.

On choisit encore plus préférentiellement une surcouche gravable de préférence avec une même solution de gravure que la couche de contact.

Dans une conception de l'invention, pour prévenir la corrosion de la couche fonctionnelle, l'électrode peut comprendre, entre la couche de blocage et la surcouche, une couche de protection contre l'oxygène et/ou l'eau, à base d'oxyde métallique tout particulièrement lorsque la surcouche est mince (inférieure ou égale à 20 nm), comme une surcouche en ITO (ou IZO/ITO ou IZO) ou en matériau précité type NiOx.

La couche de protection peut être de préférence à base de l'un au moins des oxydes métalliques suivants distincts des matériaux de la surcouche : oxyde de zinc, oxyde d'indium, oxyde d'étain, oxyde d'aluminium, oxyde de titane, oxyde de zirconium, oxyde de tantale, oxyde de silicium.

L'oxyde métallique peut être dopé typiquement, entre 2 et 5 %. Il s'agit en particulier d'oxyde d'étain dopé par S, ou d'oxyde de zinc dopé Zn0(x) dopé par Al (AZO) pour une meilleure stabilité, Ga (GZO) pour augmenter la conductivité, voire par B, Sc, ou Sb.

La couche de protection peut être à base d'oxyde mixte notamment d'un oxyde mixte de zinc et d'étain SnₓZn_{y}O_{z} généralement non stoechiométrique et sous phase amorphe, ou d'un oxyde mixte d'indium et d'étain (ITO), d'un oxyde mixte d'indium et de zinc (IZO).

La couche de protection peut être une monocouche ou une multicouche. Cette couche de protection est de préférence d'épaisseur (totale) entre 3 et 150 nm encore plus préférentiellement entre 5 et 100 nm.

Naturellement, l'ajout de cette couche dédiée à la protection permet une plus grande liberté dans le choix de la surcouche uniquement choisie pour avoir des propriétés de surface optimales notamment d'adaptation du travail de sortie pour les OLEDS.

On choisit de préférence une couche de protection facile et/ou rapide à réaliser, transparente, notamment une couche, dopée ou non, à base d'ITO, IZO, SnₓZn_{y}O_{z}, ZnOₓ.

On choisit encore plus préférentiellement une couche de protection gravable de préférence avec une même solution de gravure que la couche de contact.

On peut déposer la couche de protection par une technique de dépôt sous vide, notamment par évaporation ou de préférence par pulvérisation cathodique assistée par champ magnétique notamment à température ambiante.

Dans un mode de réalisation préféré de l'invention, la couche de contact et la couche de protection sont de nature identique, en particulier de l'oxyde de zinc pur, dopé voire allié, et de préférence la surcouche comprend de l'ITO en couche la plus extérieure.

On peut de préférence adapter l'état d'oxydation et/ou les conditions de fabrication de la couche qui surmonte la fine couche de blocage (soit la couche de protection, soit la surcouche) en fonction de la nature de la fine couche de blocage.

Ainsi lorsque la fine couche de blocage est métallique, on peut choisir une couche sus jacente sur stoechiométrique et/ou utiliser un plasma très réactif afin d'oxyder la couche métallique pour diminuer son absorption.

Inversement, lorsque la fine couche de blocage est à base de nitrure et/ou d'oxyde métallique sous stoechiométrique, on dépose une couche pure ou dopée d'oxyde métallique M(N)Ox', avec x' inférieur à 1 pour limiter la suroxydation de la fine couche de blocage et avec x' légèrement inférieur à 1 pour éviter une trop forte absorption de cette couche sus-jacente plus épaisse. On préfère en particulier une couche à base d'oxyde de zinc ZnOx', avec x' inférieur à 1, préférentiellement compris entre de 0,88 à 0,98, notamment de 0,90 à 0,95.

Avantageusement, l'électrode selon l'invention peut présenter l'une ou les caractéristiques suivantes :
- une résistance carré inférieure ou égale à 10 Ω/carré pour une épaisseur de couche fonctionnelle à partir de 6 nm, de préférence inférieure ou égale à 5 Ω/carré pour une épaisseur de couche fonctionnelle à partir de 10 nm, combinée de préférence à une transmission lumineuse T_{L} supérieure ou égale à 70%, encore plus préférentiellement à 80% ce qui rend son utilisation en tant qu'électrode transparente particulièrement satisfaisante,
- une résistance carré inférieure ou égale à 1 Ω/carré pour une épaisseur de couche fonctionnelle à partir de 50 nm, de préférence inférieure ou égale à 0,6 Ω/carré, combinée de préférence une réflexion lumineuse R_{L} supérieure ou égale à 70%, encore plus préférentiellement à 80%, ce qui rend son utilisation en tant qu'électrode réfléchissante particulièrement satisfaisante,
- une résistance carré inférieure ou égale à 3 Ω/carré pour une épaisseur de couche fonctionnelle à partir de 20 nm, de préférence inférieure ou égale à 1,8 Ω/carré, combinée de préférence un rapport T_{L} sur R_{L} entre 0,1 et 0,7, ce qui rend son utilisation en tant qu'électrode semi transparente particulièrement satisfaisante,
- la surface de la surcouche peut être de rugosité RMS (autrement appelé Rq) inférieure ou égale à 3 nm, de préférence inférieure ou égale à 2 nm, encore plus préférentiellement inférieure ou égale à 1,5 nm, afin d'éviter les défauts de pointes (« spike effect » en anglais) qui réduisent drastiquement la durée de vie et la fiabilité notamment de l'OLED.

La rugosité R.M.S signifie rugosité « Root Mean Square ». Il s'agit d'une mesure consistant à mesurer la valeur de l'écart quadratique moyen de la rugosité. Cette rugosité R.M.S, concrètement, quantifie donc en moyenne la hauteur des pics et creux de rugosité, par rapport à la hauteur moyenne. Ainsi, une rugosité R.M.S de 2 nm signifie une amplitude de pic double.

Elle peut être mesurée de différentes manières : par exemple, par microscopie à force atomique, par un système mécanique à pointe (utilisant par exemple les instruments de mesure commercialisés par la société VEECO sous la dénomination DEKTAK), par interférométrie optique. La mesure se fait généralement sur un micromètre carré par microscopie à force atomique, et sur une surface plus importante, de l'ordre de 50 micromètres à 2 millimètres pour les systèmes mécaniques à pointe.

La couche fonctionnelle est à base d'un matériau pur choisi parmi l'argent Ag, l'Au, le Cu ou l'Al ou à base dudit matériau allié ou dopé avec Ag, Au, Al, Pt, Cu, Zn, In, Si, Zr, Mo, Ni, Cr, Mg, Mn, Co, Sn, Pd. On peut citer par exemple de l'argent dopé au Pd ou un alliage or cuivre ou un alliage argent or.

On peut déposer la couche fonctionnelle par une technique de dépôt sous vide, notamment par évaporation ou de préférence par pulvérisation cathodique assistée par champ magnétique, notamment à température ambiante.

Si une haute conductivité est particulièrement recherchée, on peut choisir de préférence un matériau pur. Si des propriétés mécaniques remarquables sont particulièrement recherchées, on peut choisir de préférence un matériau dopé ou allié.

On choisit de préférence une couche à base d'argent pour sa conductivité et sa transparence.

L'épaisseur de la couche fonctionnelle choisie à base d'argent peut être comprise entre 3 à 20 nm, préférentiellement comprise entre 5 à 15 nm. Dans cette gamme d'épaisseurs, l'électrode demeure transparente.

Il n'est cependant pas exclu d'avoir une couche nettement plus épaisse notamment dans le cas où le système électroluminescent organique fonctionne en réflexion. L'épaisseur de la couche fonctionnelle choisie à base d'argent peut être comprise entre 50 et 150 nm, préférentiellement comprise entre 80 à 100 nm.

L'épaisseur de la couche fonctionnelle choisie à base d'argent peut en outre être comprise entre 20 à 50 nm pour basculer d'un fonctionnement principalement en transmission, à un fonctionnement principalement en réflexion.

La couche de contact peut être de préférence à base de l'un au moins des oxydes métalliques suivants stoechiométriques ou non : oxyde de chrome, oxyde d'indium, oxyde de zinc, oxyde d'aluminium, oxyde de titane, oxyde de molybdène, oxyde de zirconium, oxyde d'antimoine, oxyde de tantale, oxyde de silice, voire oxyde d'étain.

L'oxyde métallique peut être dopé typiquement, entre 0,5 et 5 %. Il s'agit en particulier d'oxyde de zinc dopé par Al (AZO), Ga (GZO), voire par B, Sc, ou Sb pour une meilleure stabilité de procédé de dépôt, voire d'oxyde d'étain dopé par F ou S.

La couche de contact peut être à base d'oxyde mixte notamment d'un oxyde mixte de zinc et d'étain SnₓZn_{y}O_{z} généralement non stoechiométrique et sous phase amorphe, ou d'un oxyde mixte d'indium et d'étain (ITO), d'un oxyde mixte d'indium et de zinc (IZO).

La couche de contact peut être une monocouche ou une multicouche. Cette couche est de préférence d'épaisseur (totale) entre 3 et 30 nm encore plus préférentiellement entre 5 et 20 nm.

On choisit de préférence une couche qui n'est pas toxique, une couche facile et/ou rapide à réaliser, éventuellement transparente si nécessaire, notamment une couche dopée ou non à base d'ITO, IZO, SnₓZn_{y}O_{z}, ZnOₓ.

On choisit encore plus préférentiellement une couche de nature cristalline suivant une direction de croissance privilégiée pour favoriser l'hétéroépitaxie de la couche métallique fonctionnelle. Cette couche peut tout particulièrement être gravable par 'RIE' (« Reactive ion etching » en anglais) ou encore plus préférentiellement par gravure humide (facilement intégrable dans la phase de fabrication et à pression atmosphérique). De préférence on utilise un même agent de gravure que la surcouche (solution acide, plasma(s) réactif(s) type Ar, CF₄ SF₆ et O₂...).

On préfère ainsi une couche d'oxyde de zinc ZnOx, avec préférentiellement x inférieur à 1, encore plus préférentiellement compris entre de 0,88 à 0,98, notamment de 0,90 à 0,95. Cette couche peut être pure ou dopée par Al ou par Ga comme déjà indiqué.

La Demanderesse a constaté que la gravure humide de l'électrode en une étape était possible même lorsque la couche fonctionnelle est relativement épaisse, par exemple entre 30 et 70 nm (en fonction de la concentration et de la solution de gravure choisie) en particulier si cette dernière est relativement poreuse. Des modifications dans les paramètres de dépôts peuvent permettre d'obtenir une certaine porosité de cette couche fonctionnelle. On peut ainsi choisir une pression relativement élevée. On peut varier aussi d'autres paramètres comme la température du procédé, le mélange des gaz utilisés lors du procédé.

Au sens de l'invention, un matériau est gravable par une solution de gravure, si ce dernier est dissout dans la solution ou est suffisamment corrodé par la solution et à tout le moins dont l'accrochage est suffisamment fragilisé pour qu'une petite action mécanique, notamment un rinçage avec un jet à faible pression suffise pour enlever le matériau.

On peut déposer la couche de contact par différentes techniques. On peut la déposer, par exemple par une technique de pyrolyse, notamment en phase gazeuse (technique souvent désignée par l'abréviation anglaise de C.V.D, pour « Chemical Vapor Deposition »).

On peut déposer la couche électroconductrice par une technique de dépôt sous vide, notamment par évaporation ou de préférence pulvérisation cathodique assistée par champ magnétique, en particulier à température ambiante. La pulvérisation peut être réactive (en partant de cibles métalliques ou sous-oxydées, en atmosphère oxydante) ou non réactive (en partant de cibles céramiques, en atmosphère inerte).

En particulier lors que la couche de contact à base d'oxyde métallique, on peut intercaler une fine couche de blocage, dite inférieure, entre la couche de contact et la couche fonctionnelle qui est à base d'un métal d'épaisseur inférieure ou égale à 5 nm, préférentiellement comprise entre 0,5 et 2 nm, et/ou d'un oxyde, oxynitrure, nitrure métallique, avec une épaisseur inférieure ou égale à 10 nm, préférentiellement comprise entre 0,5 et 2 nm par exemple à base des matériaux précités pour la couche de blocage.

Cette fine couche de blocage inférieure (mono ou multicouche) sert de couche d'accrochage, de nucléation et/ou de protection lors d'un éventuel traitement thermique postérieurement au dépôt.

L'électrode selon l'invention peut être associée en outre à une couche de fond susceptible de former une barrière aux alcalins, notamment lorsque la couche de contact est à base d'oxyde.

La couche de fond confère à l'électrode selon l'invention de nombreux atouts. Elle est d'abord susceptible d'être une barrière aux alcalins sous jacents à l'électrode. Elle protège de toute pollution la couche de contact (pollutions qui peuvent entraîner des défauts mécaniques tels que des délaminations); elle préserve en outre la conductivité électrique de la couche fonctionnelle métallique. Elle évite aussi que la structure organique d'un dispositif OLED ne soit polluée par les alcalins réduisant de fait considérablement la durée de vie de l'OLED.

La migration des alcalins peut intervenir pendant la fabrication du dispositif, engendrant un manque de fiabilité, et/ou postérieurement, réduisant sa durée de vie.

La couche de fond améliore les propriétés d'accrochage de la couche de contact sans accroître notablement la rugosité de l'ensemble.

L'invention trouve naturellement un intérêt tout particulièrement pour un substrat porteur susceptible de relarguer des alcalins tels que le verre silicosodocalcique notamment clair, extraclair.

Par ailleurs, grâce à cette structure d'empilement particulière, on obtient en outre une électrode fiable, permettant des gains de productivité significatifs.

La couche de fond est robuste, facile et rapide à déposer suivant différentes techniques. On peut la déposer, par exemple par une technique de pyrolyse, notamment en phase gazeuse (technique souvent désignée par l'abréviation anglaise de C.V.D, pour « Chemical Vapor Deposition »). Cette technique est intéressante pour l'invention car des réglages appropriés des paramètres de dépôt permettent d'obtenir une couche très dense pour une barrière renforcée.

On peut déposer la couche de fond par une technique de dépôt sous vide, notamment par évaporation ou pulvérisation cathodique assistée par champ magnétique, en particulier à température ambiante.

La couche de fond peut être éventuellement dopée à l'aluminium pour rendre son dépôt sous vide plus stable.

La couche de fond (monocouche ou multicouche, éventuellement dopée) peut être d'épaisseur entre 10 et 150 nm, encore plus préférentiellement entre 20 et 100 nm.

La couche de fond peut être de préférence :
- à base d'oxyde de silicium d'oxycarbure de silicium, couche de formule générale Si0C
- à base de nitrure de silicium, d'oxynitrure de silicium, d'oxycarbonitrure de silicium, couche de formule générale SiNOC, notamment SiN en particulier Si₃N₄.

L'électrode peut comprendre de manière préférentielle une couche d'arrêt de gravure humide entre la couche de fond et la couche de contact, notamment une couche à base d'oxyde d'étain, couche notamment d'épaisseur entre 10 et 100 nm, encore plus préférentiellement entre 20 et 60 nm. Ou tout particulièrement, pour souci de simplicité, la couche d'arrêt de gravure humide peut faire partie ou être la couche de fond : elle peut être de préférence à base de nitrure de silicium ou elle peut être une couche qui est à base de d'oxyde de silicium ou à base d'oxycarbure de silicium et avec de l'étain pour renforcer par propriété d'anti gravure humide, couche de formule générale SnSiOCN.

La couche d'arrêt de gravure humide sert à protéger le substrat dans le cas d'une gravure chimique ou une gravure par plasma réactif.

Grâce à l'arrêt de gravure (sèche ou humide), la couche de fond reste présente même dans la ou les zones gravées (« patterned » en anglais). Aussi, la migration des alcalins, par effet de bord, entre le substrat dans une zone gravée et une partie d'électrode adjacente (voire une structure organique) peut être stoppée.

On peut préférer tout particulièrement une couche de fond/d'arrêt de gravure (essentiellement) en nitrure de silicium Si₃N₄, dopé ou non. Le nitrure de silicium est très rapide à déposer et forme une excellente barrière aux alcalins. En outre, grâce à son indice optique élevé par rapport au substrat porteur, il permet d'adapter les propriétés optiques de l'électrode en jouant de préférence sur l'épaisseur de cette couche de fond. Cela permet ainsi d'ajuster par exemple la couleur en transmission lorsque l'électrode est transparente ou en réflexion lorsque la face opposée du substrat porteur est un miroir.

De manière avantageuse, la couche de fond et de préférence l'éventuelle couche d'arrêt de gravure (humide) peuvent couvrir sensiblement la (quasi) totalité d'une face principale d'un substrat plan verrier.

Et encore plus préférentiellement, les couches de contact, de blocage inférieure (optionnelle), la couche fonctionnelle, la fine couche de blocage, et le revêtement sont structurés suivant un même motif de gravure et de préférence par une seule gravure humide, ce qui sera détaillé plus avant dans la présente demande.

La couche d'arrêt de gravure, si elle est présente, est de préférence intacte, mais peut se trouver légèrement gravée, par exemple sur un dixième de son épaisseur initiale. Il en est de préférence de même pour la couche de fond si la couche d'arrêt de gravure n'est pas présente.

L'électrode peut être plus large que la structure organique ou autre élément par dessus pour faciliter les prises de contacts électriques.

En outre, une bordure de la surcouche peut être surmontée d'une bande d'amenée de courant (continue ou discontinue, formant une partie d'un collecteur ou d'un distributeur de courant) de préférence d'épaisseur comprise entre 0,5 à 10 µm et sous forme d'une monocouche métallique en l'un des métaux suivants : Mo, Al, Cr, Nd ou en alliage de métaux tels que MoCr, AlNd ou d'une multicouche métallique telle que MoCr/Al/MoCr.

Cette bande peut être conçue pendant la phase de gravure.

Les moyens d'alimentation électrique peuvent aussi être rajoutés postérieurement à la gravure, par exemple être en émail conducteur, par exemple à l'argent et sérigraphiés.

Dans des modes de réalisation préférés de l'invention, on peut éventuellement avoir recours en outre à l'une et/ou à l'autre des dispositions suivantes :
- l'épaisseur totale d'ITO voire d'indium dans l'électrode peut être inférieure ou égale à 30 nm, voire à 20 nm,
- l'épaisseur totale (avec la couche de fond) est entre 30 nm et 250 nm.

L'invention ne s'applique pas seulement à des empilements ne comportant qu'une seule couche « fonctionnelle ». Elle s'applique aussi à des empilements comportant une pluralité de couches fonctionnelles, notamment deux couches fonctionnelles alternées avec deux ou trois revêtements.

Dans le cas d'un empilement pluri-couches fonctionnelles, au moins une, et de préférence chaque couche fonctionnelle est munie d'une couche « sur » blocage selon l'invention (voire d'une couche de sous blocage).

Ainsi, sur les éventuelles couche de fond et/ou couche d'arrêt de gravure humide, l'électrode comprend n fois la structure suivante, avec n un nombre entier supérieur ou égal à 1 : la couche de contact, éventuellement la fine couche de blocage inférieure, la couche fonctionnelle, la fine couche de blocage, éventuellement la couche de protection à l'eau et/ou à l'oxygène, la structure étant surmontée d'une séquence comprenant la couche de contact, la couche fonctionnelle, la fine couche de blocage, éventuellement la couche de protection à l'eau et/ou à l'oxygène, ladite surcouche.

Le substrat plan peut être transparent (en particulier pour une émission à travers le susbtrat). Le substrat plan peut être rigide, flexible ou semi-flexible.

Ses faces principales peuvent être rectangulaires, carrées ou même de toute autre forme (ronde, ovale, polygonale...). Ce substrat peut être de grande taille par exemple de surface supérieure à 0,02m², voire même 0.5 m² ou 1 m² et avec une électrode inférieure occupant sensiblement la surface (aux zones de structuration près).

Le substrat plan est de préférence verrier, notamment en verre silicosodocalcique. Le substrat peut être avantageusement un verre présentant un coefficient d'absorption inférieur à 2,5 m⁻¹, de préférence inférieur à 0,7 m⁻¹ à la longueur d'onde du ou des rayonnements OLEDs.

On choisit par exemple des verres silicosodocalciques avec moins de 0,05% de Fe III ou de Fe₂O₃, notamment le verre Diamant de Saint-Gobain Glass, le verre Optiwhite de Pilkington, le verre B270 de Schott. On peut choisir toutes les compositions de verre extraclair décrites dans le document WO04/025334.

Dans une configuration choisie d'une émission du système OLED à travers l'épaisseur du substrat transparent, une partie du rayonnement émis est guidé dans le substrat.

Aussi, dans une conception avantageuse de l'invention, l'épaisseur du substrat choisi verrier peut être d'au moins 1 mm, de préférence d'au moins 5 mm, par exemple. Cela permet de diminuer le nombre de réflexions internes et d'extraire ainsi plus de rayonnement guidé dans le verre, augmentant ainsi la luminance de la zone lumineuse.

Les bords de la tranche peuvent en outre être réfléchissants, et comporter de préférence un miroir, pour assurer un recyclage optimal du rayonnement guidé et les bords, forment avec la face principale associée au système OLED un angle externe supérieur ou égal à 45° et inférieur à 90°, de préférence supérieur ou égal à 80°, pour rediriger les rayonnements sur une plus large zone d'extraction. La tranche peut être ainsi biseautée.

Pour séparer électriquement les électrodes dans le document JP2005-038642, l'électrode inférieure est structurée en plusieurs étapes de gravure impliquant différents acides et à différentes vitesses de gravure. On grave ainsi d'abord la couche d'adaptation du travail de sortie, puis la couche métallique et enfin la couche de contact.

Le but que se fixe l'invention est de parvenir à obtenir un assemblage de couches électroconductrices pour former une électrode fiable, robuste (notamment en termes de stabilité et/ou de tenue thermique, mécanique) sans sacrifier ses propriétés d'électroconductivité, sa qualité optique, ni les performances du dispositif l'incorporant, ni engendrer des difficultés de réalisation notamment de gravure humide.

L'invention propose ainsi un procédé de gravure acide d'une électrode multicouche sur un substrat, notamment verrier, comportant une couche d'arrêt de gravure acide, de préférence à base de nitrure de silicium, l'électrode comportant :
- une couche de contact en oxyde métallique dopé ou non choisi parmi l'oxyde de zinc, l'oxyde mixte d'étain et de zinc, d'étain et d'indium, d'indium et de zinc, (ZnOx, SnxZnyOz ITO ou IZO),
- éventuellement une fine couche de blocage inférieure directement sous une couche fonctionnelle, la couche comprenant une couche métallique d'épaisseur inférieure ou égale à 5 nm et/ou une couche avec une épaisseur inférieure ou égale à 10 nm, qui est à base d'oxyde ou d'oxynitrure métallique ou de nitrure métallique sous stoechiométrique,
- la couche fonctionnelle métallique à propriétés intrinsèques de conductivité électrique d'épaisseur inférieure ou égale à 70 nm et choisie parmi l'argent et/ou l'or, dopée ou non,
- une fine couche de blocage directement sur la couche fonctionnelle, la couche comprenant une couche métallique d'épaisseur inférieure ou égale à 5 nm et/ou une couche avec une épaisseur inférieure ou égale à 10 nm, qui est à base d'oxyde ou d'oxynitrure métallique ou de nitrure métallique sous stoechiométrique,
- éventuellement une couche de protection en oxyde métallique dopé ou non choisie parmi l'oxyde de zinc, l'oxyde mixte d'étain et de zinc, d'étain et d'indium, d'indium et de zinc,
- et une surcouche en oxyde conducteur éventuellement mixte choisi parmi l'oxyde d'indium, l'oxyde de zinc, l'oxyde d'étain et/ou une surcouche d'épaisseur inférieure ou égale à 10 nm en oxyde sous stoechiométrique choisi parmi l'oxyde de molybdène, oxyde de nickel, oxyde d'aluminium, oxyde de titane, oxyde de zirconium, oxyde de tantale, oxyde de silicium, oxyde d'argent, d'or, de platine, de palladium, la gravure étant réalisée en une étape et avec une solution d'acide choisie parmi l'acide nitrique HNO₃ pur en ou mélange avec de l'acide chlorhydrique HCl ou l'acide chlorhydrique pur en ou mélange avec du trichlorure de fer FeCl₃ autrement dit chlorure de Fe III.

Naturellement la couche d'arrêt de gravure peut être la couche de fond déjà présentée plus haut.

On peut ainsi graver à façon des motifs de gravure dont la largeur et l'espacement varient en fonction des applications.

La gravure peut être réalisée en présence d'au moins une bande métallique d'amenée de courant, sous forme d'une monocouche de préférence à base de l'un des métaux suivants Mo, Al, Cr, Nd ou en alliage tel que MoCr, AlNd ou en multicouche telle que MoCr/Al/MoCr.

L'invention a trait également à un dispositif électroluminescent organique comportant au moins un substrat porteur, notamment verrier, muni d'au moins une couche électroluminescente organique disposée entre l'électrode inférieure telle que décrite précédemment et une électrode dite supérieure.

Le dispositif OLED peut produire de la lumière monochromatique, notamment bleue et/ou verte et/ou rouge, ou être adaptée pour produire une lumière blanche.

Pour produire de la lumière blanche plusieurs méthodes sont possibles : mélange de composés (émission rouge vert, bleu) dans une seule couche, empilement sur la face des électrodes de trois structures organiques (émission rouge vert, bleu) ou de deux structures organiques (jaune et bleu), série de trois structures organiques adjacentes (émission rouge vert, bleu), sur la face des électrodes une structure organique dans une couleur et sur l'autre face des couches luminophores adaptées.

Le dispositif OLED peut comprendre une pluralité de systèmes électroluminescents organiques adjacents, chacun émetteur de lumière blanche ou, par série de trois, de lumière rouge, verte et bleu, les systèmes étant par exemple connectés en série.

Le dispositif peut faire partie d'un vitrage multiple, notamment un vitrage sous vide ou avec lame d'air ou autre gaz. Le dispositif peut aussi être monolithique, comprendre un vitrage monolithique pour gagner en compacité et/ou en légèreté.

Le système OLED peut être collé ou de préférence feuilleté avec un autre substrat plan dit capot, de préférence transparent tel qu'un verre, à l'aide d'un intercalaire de feuilletage, notamment extraclair.

Les vitrages feuilletés sont usuellement constitués de deux substrats rigides entre lesquels est disposée une feuille ou une superposition de feuilles de polymère du type thermoplastique. L'invention inclut aussi les vitrages feuilletés dits « asymétriques » utilisant un substrat notamment porteur rigide du type verre et comme substrat couvrant une ou des feuilles protectrices de polymère.

L'invention inclut aussi les vitrages feuilletés ayant au moins une feuille intercalaire à base d'un polymère adhésif simple ou double face du type élastomère (c'est-à-dire ne nécessitant pas une opération de feuilletage au sens classique du terme, feuilletage imposant un chauffage généralement sous pression pour ramollir et rendre adhérente la feuille intercalaire thermoplastique).

Dans cette configuration, le moyen pour solidariser capot et substrat porteur peut être alors un intercalaire de feuilletage notamment une feuille de matière thermoplastique par exemple en polyuréthane (PU), en polyvinylbutyral (PVB), en éthylène vinylacétate (EVA), ou être en résine pluri ou mono- composants réticulables thermiquement (époxy, PU) ou aux ultraviolets (époxy, résine acrylique). Elle est de préférence (sensiblement) de même dimension que le capot et le substrat.

L'intercalaire de feuilletage peut permettre d'éviter un fléchissement du capot notamment pour des dispositifs de grande dimension par exemple de surface supérieure à 0,5m².

L'EVA offre en particulier de multiples avantages :
- il n'est pas ou peu chargé en eau en volume,
- il ne nécessite pas nécessairement une mise sous pression élevée pour sa mise en oeuvre.

Un intercalaire de feuilletage thermoplastique peut être préféré à une couverture en résine coulée car elle est à la fois plus facile à mettre en oeuvre, plus économique et est éventuellement plus étanche.

L'intercalaire comporte éventuellement un réseau de fils électroconducteurs incrustés sur sa surface, dite interne, en regard de l'électrode supérieure, et/ou une couche électroconductrice ou des bandes électroconductrices sur la surface interne du capot.

Le système OLED peut être disposé de préférence à l'intérieur du double vitrage, avec une lame de gaz notamment inerte (argon par exemple).

L'électrode supérieure peut être une couche électroconductrice avantageusement choisie parmi les oxydes métalliques notamment les matériaux suivants :
- l'oxyde de zinc dopé, notamment à l'aluminium ZnO:Al ou au gallium ZnO:Ga,
- ou encore l'oxyde d'indium dopé, notamment à l'étain (ITO) ou l'oxyde d'indium dopé au zinc (IZO).

On peut utiliser plus généralement tout type de couche électroconductrice transparente, par exemple une couche dite « TCO » (pour « Transparent Conductive Oxyde » en anglais), par exemple d'épaisseur entre 20 et 1000 nm.

On peut aussi utiliser une couche mince métallique dite « TCC » (pour « Transparent conductive coating » en anglais) par exemple en Ag, Al, Pd, Cu, Pd, Pt In, Mo, Au et typiquement d'épaisseur entre 5 et 150 nm en fonction de la transmission/réflexion lumineuse souhaitée.

L'électrode n'est pas forcément continue. L'électrode supérieure peut comprendre une pluralité de bandes conductrices ou de fils conducteurs (grille).

En outre, il peut être avantageux d'ajouter un revêtement ayant une fonctionnalité donnée sur la face opposée du substrat porteur de l'électrode selon l'invention ou sur un substrat additionnel. Il peut s'agir d'une couche anti-buée (à l'aide d'une couche hydrophile), anti-salissures (revêtement photocatalytique comprenant du TiO₂ au moins partiellement cristallisé sous forme anatase), ou encore un empilement anti-reflet du type par exemple Si₃N_{4/}SiO_{2/}Si₃N_{4/}SiO₂ ou encore un filtre aux UV comme par exemple une couche d'oxyde de titane (TiO₂). Il peut en outre s'agir d'une ou plusieurs couches luminophores, d'une couche miroir, d'au moins une zone diffusante d'extraction de lumière.

L'invention concerne également les diverses applications que l'on peut trouver à ces dispositifs OLEDS, formant une ou des surfaces lumineuses transparentes et/ou réfléchissantes (fonction miroir) disposés aussi bien en extérieur qu'en intérieur.

Le dispositif peut former (choix alternatif ou cumulatif) un système éclairant, décoratif, architectural, etc...), un panneau d'affichage de signalisation - par exemple du type dessin, logo, signalisation alphanumérique, notamment un panneau d'issue de secours.

Le dispositif OLED peut être arrangé pour produire une lumière uniforme, notamment pour un éclairage homogène, ou pour produire différentes zones lumineuses, de même intensité ou d'intensité distincte.

Inversement, on peut rechercher un éclairage différencié. Le système électroluminescent organique (OLED) produit une zone de lumière directe, et une autre zone lumineuse est obtenue par extraction du rayonnement OLED qui est guidé par réflexions totales dans l'épaisseur du substrat choisi verrier.

Pour former cette autre zone lumineuse, la zone d'extraction peut être adjacente au système OLED ou de l'autre côté du substrat. La ou les zones d'extraction peuvent servir par exemple pour renforcer l'éclairage fourni par la zone de lumière directe, notamment pour un éclairage de type architectural, ou encore pour signaler le panneau lumineux. La ou les zones d'extraction sont de préférence sous forme de bande(s) de lumière, notamment uniforme(s), et préférentiellement disposée(s) en périphérie d'une des faces. Ces bandes peuvent par exemple former un cadre très lumineux.

L'extraction est obtenue par l'un au moins des moyens suivants disposés dans la zone extraction : une couche diffusante, de préférence à base de particules minérales et de préférence avec un liant minéral, le substrat rendu diffusant, notamment texturé ou rugueux.

Les deux faces principales peuvent avoir chacune une zone de lumière directe.

Lorsque les électrodes et la structure organique du système OLED sont choisies transparentes, on peut réaliser notamment une fenêtre éclairante. L'amélioration de l'éclairage de la pièce n'est alors pas réalisée au détriment de la transmission lumineuse. En limitant en outre la réflexion lumineuse notamment du côté extérieur de la fenêtre éclairante, cela permet aussi de contrôler le niveau de réflexion par exemple pour respecter les normes anti-éblouissement en vigueur pour les façades de bâtiments.

Plus largement, le dispositif, notamment transparent par partie(s) ou entièrement, peut être :
- destiné au bâtiment, tel qu'un vitrage lumineux extérieur, une cloison lumineuse interne ou une (partie de) porte vitrée lumineuse notamment coulissante,
- destiné à un véhicule de transport, tel qu'un toit lumineux, une (partie de) vitre latérale lumineuse, une cloison lumineuse interne d'un véhicule terrestre, aquatique ou aérien (voiture, camion train, avion, bateau, etc),
- destiné au mobilier urbain ou professionnel tel qu'un panneau d'abribus, une paroi d'un présentoir, d'un étalage de bijouterie ou d'une vitrine, une paroi d'une serre, une dalle éclairante,
- destiné à l'ameublement intérieur, un élément d'étagère ou de meuble, une façade d'un meuble, une dalle éclairante, un plafonnier, une tablette éclairante de réfrigérateur, une paroi d'aquarium,
- destiné au rétro-éclairage d'un équipement électronique, notamment d'écran de visualisation ou d'affichage, éventuellement double écran, comme un écran de télévision ou d'ordinateur, un écran tactile.

On peut par exemple concevoir un rétro-éclairage d'un écran double face avec des tailles différentes, l'écran de petite taille étant de préférence associé à une lentille de Fresnel pour concentrer la lumière.

Pour former un miroir éclairant, l'une des électrodes peut être réfléchissante ou un miroir peut être disposé sur la face opposée au système OLED, si l'on souhaite privilégier un éclairage d'un seul côté dans la zone de lumière directe.

Il peut être aussi un miroir. Le panneau lumineux peut servir à l'éclairage d'une paroi de salle de bains ou d'un plan de travail de cuisine, être un plafonnier.

Les OLED sont généralement dissociés en deux grandes familles suivant le matériau organique utilisé.

Si les couches électroluminescentes sont des petites molécules, on parle de SM-OLED (« Small Molecule Organic Light Emitting Diodes » en anglais). Le matériau électroluminescent organique de la couche mince est constitué à partir de molécules évaporées comme par exemple le complexe d'AlQ₃ (tris(8-hydroxyquinoline) aluminium), le DPVBi (4,4'-(diphényl vinylène biphényl)), le DMQA (diméthyl quinacridone) ou le DCM (4-(dicyanométhylène)-2-méthyl-6-(4-diméthylaminostyryl)-4H-pyran). La couche émissive peut être aussi par exemple par une couche de 4,4',4"-tri(N-carbazolyl) triphenylamine (TCTA) dopé au fac tris(2-phenylpyridine) iridium [Ir(ppy)₃].

D'une manière générale la structure d'une SM-OLED consiste en un empilement de couches d'injection de trous ou « HIL » pour « Hole Injection Layer » en anglais, couche de transport de trous ou « HTL » pour « Hole Transporting Layer » en anglais, couche émissive, couche de transport d'électron ou « ETL » pour « Electron Transporting Layer » en anglais.

Un exemple de couche d'injection de trous est le phthalocyanine de cuivre (CuPC), la couche de transport de trous peut être par exemple le N,N'-Bis(naphthalen-1-yl)-N,N'-bis(phenyl)benzidine (alpha-NPB).

La couche de transport d'électron peut être composée de tris-(8-hydroxyquinoline) aluminum (Alq₃) ou le bathophenanthroline (BPhen).

L'électrode supérieure peut être une couche de Mg/Al ou LiF/Al.

Des exemples d'empilements électroluminescents organiques sont par exemple décrits dans le document US6645645.

Si les couches électroluminescentes organiques sont des polymères, on parle de PLED (« Polymer Light Emitting Diodes » en anglais).

Le matériau électroluminescent organique de la couche mince est constitué à partir de CES polymères (pLEDs) comme par exemple le PPV pour poly(*para*-phénylène vinylène), le PPP (poly(*para*-phénylène), le DO-PPP (poly(2-décyloxy-1,4-phénylène), le MEH-PPV (poly[2-(2'-éthylhexyloxy)-5-méthoxy-1,4-phénylène vinylène)]), le CN-PPV (poly[2,5-bis(hexyloxy)-1,4-phénylène-(1-cyanovinylène)]) ou les PDAF (poly(dialkylfluorène), la couche de polymère est associée également à une couche qui favorise l'injection des trous (HIL) constituée par exemple du PEDT/PSS (poly (3,4-ethylène-dioxythiophène/poly(4-styrène sulfonate)).

Un exemple de PLED consiste en un empilement suivant :
- une couche de poly(2,4-ethilene dioxythiophene) dopé au poly(styren sulphonate) (PEDOT :PSS) de 50nm,
- une couche de phenyl poly (p-phenylenevynilene) Ph-PPV de 50nm. L'électrode supérieure peut être une couche de Ca.

L'invention sera maintenant décrite plus en détails à l'aide d'exemples non limitatifs et de figures :
- La figure 1 est une vue schématique en coupe d'un dispositif électroluminescent organique, pour un (rétro)éclairage uniforme, lequel comprend une électrode inférieure conforme à l'invention dans un premier mode de réalisation, la figure 2 est une vue partielle montrant cette électrode inférieure plus en détail,
- la figure 3 illustre un procédé de fabrication et de gravure de cette électrode,
- la figure 4 illustre une vue schématique en coupe d'un dispositif électroluminescent organique, pour un (rétro)éclairage uniforme, lequel est arrangé sur plusieurs zones, et comprend une électrode inférieure conforme à l'invention dans un deuxième mode de réalisation,
- les figures 5 et 6 illustrent des vues schématiques de dessus montrant deux schémas de connexions électriques d'électrodes similaires à celles utilisées dans le deuxième mode de réalisation,
- la figure 7 représente une vue schématique en coupe latérale d'un dispositif électroluminescent organique utilisé pour un éclairage différencié.

On précise que par un souci de clarté les différents éléments des objets (y compris les angles) représentés ne sont pas nécessairement reproduits à l'échelle.

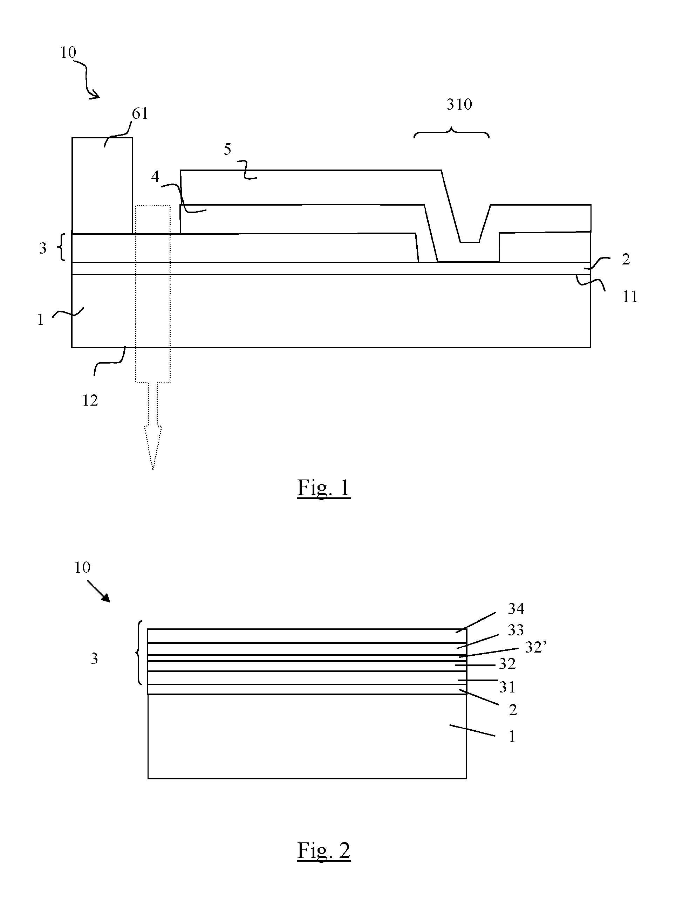

La figure 1 est volontairement très schématique, elle représente en coupe un dispositif électroluminescent organique 10 (à émission à travers le substrat ou « bottom emission » en anglais) comprenant un substrat plan de verre silico-sodo-calcique 1, clair ou extraclair, de 2,1 mm d'épaisseur, avec des première et deuxième faces principales 11, 12. La première face principale 11 comporte :
- une couche de fond 2, déposée directement sur la première face principale 11, faisant office également d'arrêt de gravure humide, en nitrure de silicium, d'épaisseur entre 10 nm et 80 nm, et couvrant sensiblement la totalité de la première face principale 11,
- une électrode inférieure 3, déposée directement sur la couche de fond 2, gravée, choisie transparente, comportant un empilement de couches (voir figure 2) du type :
   - une couche de contact 31 choisie parmi ZnOx dopée ou non, SnₓZn_{y}O_{z}, ITO ou IZO,
   - une couche fonctionnelle 32 en argent de préférence pur, directement sur la couche de contact 31,
   - une fine couche de blocage 32' directement sur la couche fonctionnelle 32, couche métallique obtenue de préférence par une cible métallique avec un plasma neutre ou en nitrure et/ou oxyde d'un ou plusieurs métaux tels que Ti, Ni, Cr, obtenue de préférence par une cible céramique avec un plasma neutre,
- un revêtement formé :
   - d'une couche de protection 33 choisie parmi ZnOx, SnₓZn_{y}O_{z}, ITO ou IZO, la couche de contact et la couche de protection contre l'eau et/ou l'oxygène étant de nature identique,
   - d'une surcouche 34 d'adaptation du travail de sortie, soit de préférence l'empilement ZnO :Al/Ag/Ti, TiOx ou NiCr/ZnO :Al/ITO d'épaisseurs respectives 5 à 20 nm pour le ZnO :Al, 5 à 15 nm pour l'argent, 0,5 à 2 nm pour le TiOx, Ti, NiCr, 5 à 20 nm pour le ZnO :Al, 5 à 20 nm pour l'ITO,
- un système électroluminescent organique 4, par exemple un SM-OLED de structure suivante :
   - une couche en alpha-NPD,
   - une couche en TCTA + Ir(ppy)₃,
   - une couche en BPhen,
   - une couche en LiF,
- une électrode supérieure réfléchissante 5, notamment métallique notamment à base d'argent ou d'aluminium.

L'ensemble des couches 2 à 5 a été déposé par pulvérisation cathodique assistée par champ magnétique, à température ambiante.

L'électrode inférieure 3 présente les caractéristiques suivantes :
- une résistance carré inférieure ou égale à 5 Ω/carré,
- une transmission lumineuse T_{L} supérieure ou égale à 70% (mesure sur pleine couche, avant la structuration), et une réflexion lumineuse R_{L} inférieure ou égale à 20%,
- une rugosité RMS (ou Rq) inférieure ou égale à 3 nm mesurée par interférométrie optique, sur un micromètre carré par microscopie à force atomique.

Pour Si₃N_{4 25nm}/ZnO:Al ₁₀ₙₘ/Ag ₁₂ₙₘ/Ti₁ₙₘ/ ZnO:Al₂₀ₘₙ/IT ₂₀ₙₘ, on obtient une TL de 83%, une résistance carré stable, une rugosité RMS de 1,3 nm. La couche de Ti est déposée par pulvérisation cathodique dans une atmosphère inerte (c'est-à-dire sans introduction volontaire d'oxygène ou d'azote) constituée de gaz noble (He, Ne, Xe, Ar, Kr).

Les conditions de dépôt pour chacune des couches sont de préférence les suivantes :
- la couche à base de Si₃N₄ est déposée par pulvérisation réactive à l'aide d'une cible en silicium dopée à l'aluminium, sous une pression de 0,8 Pa dans une atmosphère argon/azote,
- la couche à base d'argent est déposée à l'aide d'une cible en argent, sous une pression de 0,8 Pa dans une atmosphère d'argon pur,
- la couche de Ti est déposée à l'aide d'une cible titane, sous une pression de 0,8 Pa dans une atmosphère d'argon pur,
- les couches à base de ZnO sont déposées par pulvérisation réactive à l'aide d'une cible de zinc dopé aluminium, sous une pression de 0,3 Pa et dans une atmosphère argon/oxygène,
- la couche d'ITO est déposée à l'aide d'une cible céramique dans une atmosphère argon/oxygène.

Pour une série de trois échantillons, chacun porteur de cet empilement Si₃N_{4 25nm}/ZnO:Al ₁₀ₙₘ/Ag ₁₂ₘₙ/Ti₁ₙₘ/ ZnO:Al₂₀ₘₙ/IT ₂₀ₙₘ, on obtient respectivement une résistance carré de 4,35 Ohm/carré, de 4,37 Ohm/carré, de 4,44 Ohm/carré soit un écart maximal de 0,11 et une résistance carré moyenne de 4,39 Ohm/carré.

Pour une série de trois échantillons comparatifs chacun porteur de cet empilement sans la fine couche de blocage, on obtient respectivement une résistance carré de 4,4 Ohm/carré, de 4,75 Ohm/carré, de 4,71 Ohm/carré soit un écart maximal de 0,35 trois fois plus élevé et une résistance carré moyenne de 4,62 Ohm/ carré.

Pour cette structure organique, l'électrode de l'invention permet d'améliorer le rendement en lm/W de l'OLED d'au moins 5 à 10% pour une brillance supérieure à 500 cd/m² par rapport à une électrode en ITO.

La première électrode peut en variante comprendre une fine couche de blocage inférieure, notamment une couche métallique obtenue de préférence par une cible métallique avec un plasma neutre ou en nitrure et/ou oxyde d'un ou plusieurs métaux tels que Ti, Ni, Cr, obtenue de préférence par une cible céramique avec un plasma neutre.

La première électrode peut en variante aussi être une électrode semi-transparente. Pour Si₃N_{4 20 mn}/ZnO:Al _{20 nm}/Ag _{30 nm}/TiOx₁ₙₘ ou NiCr₁ₙₘ/ZnO:Al ₄₀ₙₘ/ITO _{20 nm}, on obtient une TL d'environ 15%, une RL d'environ 80%, une résistance carré de 0,9 Ohm/carré.

La première électrode peut aussi être une électrode réfléchissante.

L'électrode inférieure 3 déborde sur un côté du verre 1. La bordure de la surcouche 34 est ainsi surmontée d'une première bande métallique 61 d'amenée de courant, de préférence d'épaisseur comprise entre 0,5 à 10 µm, par exemple 5 µm, et sous forme d'une couche en l'un des métaux suivants : Mo, Al, Cr, Nd ou en alliage tel que MoCr, AlNd ou en multicouche tel que MoCr/Al/MoCr.

L'électrode inférieure 3 peut en variante comprendre la couche de fond et une structure répétée n fois, avec n un nombre entier supérieur ou égal à 1, cette structure étant la suivante : la couche de contact/la couche fonctionnelle/la fine couche de blocage/éventuellement la couche de protection à l'eau et/ou à l'oxygène.

Cette structure est surmontée d'une séquence comprenant la couche de contact/la couche fonctionnelle/éventuellement la couche de protection à l'eau et/ou à l'oxygène/ladite surcouche.

Dans le cas d'un empilement de structures organiques par exemple émettant dans le rouge, le vert, le bleu, pour produire une lumière blanche, on peut par ailleurs répéter trois fois l'ensemble des éléments 3, 4, 5 ou bien simplement utiliser une multicouche Al/ITO ou Ag/éventuellement une fine couche de blocage similaire/ITO ou Ag/éventuellement une fine de couche blocage similaire/ZnO/ITO pour les électrodes inférieures supplémentaires.

L'électrode supérieure déborde sur le côté opposé du verre 1. Cette bordure de l'électrode supérieure 5 est éventuellement surmontée d'une deuxième bande métallique d'amenée de courant, de préférence similaire à la première bande métallique. Cette deuxième bande est préférable dans le cas où l'électrode supérieure est d'épaisseur inférieure ou égale à 50 nm.

La deuxième électrode peut en effet aussi être, en variante, une électrode transparente ou semi transparente et par exemple être identique à la première électrode. On rapporte éventuellement dans ce cas un réflecteur sur la deuxième face 12 par exemple une couche métallique d'épaisseur 150 nm

Une feuille type EVA peut permettre de feuilleter le verre 1 à un autre verre de préférence de mêmes caractéristiques que le verre 1. Optionnellement, la face du verre 12 tournée vers la feuille d'EVA est munie d'un empilement de fonctionnalité donnée décrite plus tard.

L'électrode inférieure 3 est en deux parties espacées par la zone de structuration 310 par exemple une ligne.

La gravure humide est utilisée pour séparer électriquement l'électrode inférieure 3 de l'électrode supérieure du dispositif 10.

Pour graver la totalité de l'électrode inférieure (couches de contact, fonctionnelle, de blocage, de protection et surcouche) suivant un même motif de gravure et en une fois, on expose les couches - préalablement en partie masquées à l'aide d'une bande adhésive résistante aux acides ou en variante avec un masque de photolithographie - à l'une des solutions acides suivantes :
- à l'HCl (par exemple à 40%),
- ou à l'HCl (par exemple à 4%),
- ou à un mélange de HCl (par exemple à 4%) et de HNO₃ (par exemple à 7 %),
- ou à un mélange de HCl et de FeCl₃,
- à l'HNO₃ entre 10 et 18%.

La gravure à l'acide chlorhydrique conduit à des profils de gravure très homogènes. Le mélange acide nitrique et acide chlorhydrique donne aussi des résultats intéressants. Le mélange de HCl et FeCl₃ est utilisé de manière classique pour l'ITO.

Le profil de gravure, le temps de gravure et la résolution peuvent être adaptés en utilisant des mélanges des deux acides et en jouant sur les concentrations.

On peut ainsi graver à façon des motifs de gravure dont la largeur et l'espacement varient en fonction des applications.

Pour des écrans OLED à matrice passive de petite taille (pour affichage d'un matériel électronique de type téléphone portable, afficheur, assistant personnel, lecteur MP3....), la largeur de chaque zone gravée peut être typiquement de 10 à 20 µm, chaque zone gravée étant espacée de 10 à 50 µm par exemple de 35 µm (correspondant à la largeur de chaque zone d'électrode).

Pour des écrans OLED à matrice passive de grande taille, par exemple pour affichage publicitaire, signalétique, la largeur de chaque zone gravée peut être de l'ordre de 0,5 mm et la largeur de chaque zone d'électrode peut être de quelques mm, quelques cm ou plus...

Pour un éclairage homogène, la largeur de chaque zone gravée peut être inférieure ou égale à 100 µm, encore plus préférentiellement à 50 µm quelle que soit la taille de l'écran.

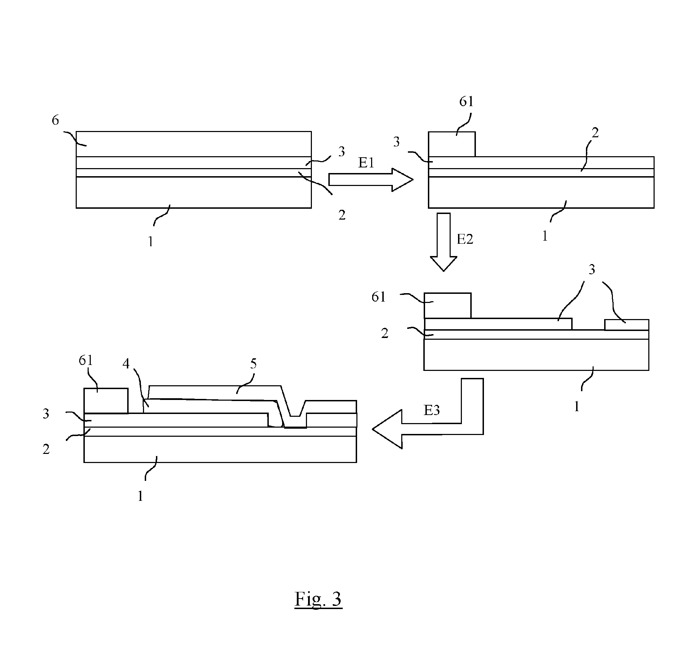

La figure 3 illustre un procédé de fabrication et de gravure de cette électrode.

Après dépôt de la couche de fond 2, de l'électrode 3 et de la couche métallique (mono ou multicouche) pour l'amenée de courant 6, on procède à la gravure de cette couche 6 avec une solution qui ne grave pas l'électrode par exemple de la soude (étape E1), puis on procède à la gravure en une étape de l'électrode inférieure 3 comme déjà indiqué (étape E2), suivi du dépôt du système OLED 4 et de l'électrode supérieure 5 par exemple en Al au-dessus (étape E3).

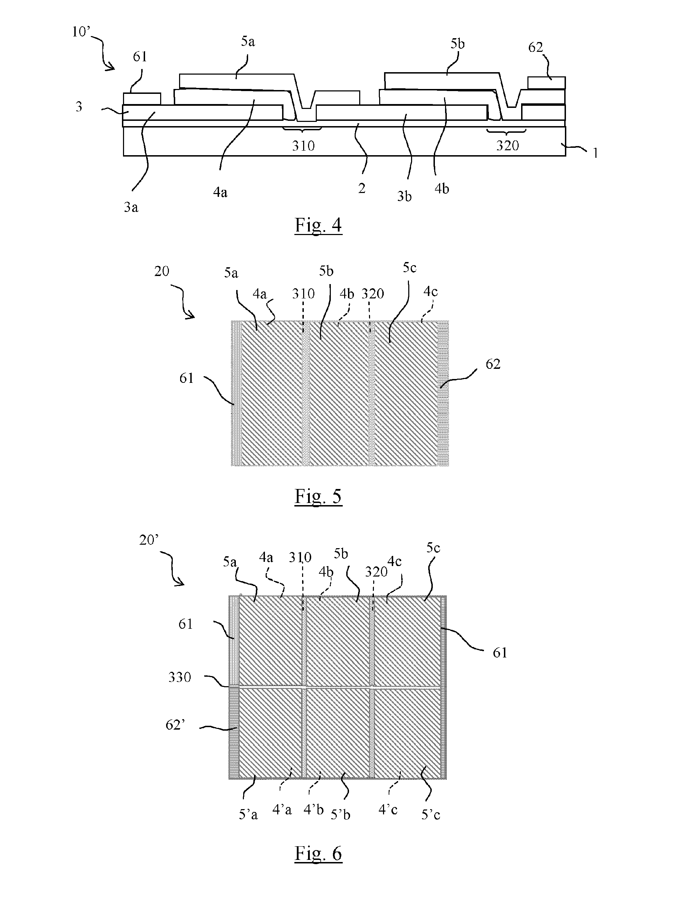

La figure 4 illustre une vue schématique en coupe d'un dispositif électroluminescent organique 10', pour un (rétro)éclairage uniforme, lequel est arrangé sur plusieurs zones, et comprend une électrode inférieure conforme à l'invention dans un deuxième mode de réalisation.

Ce deuxième dispositif 10' diffère du premier dispositif 10 par les éléments décrits ci après.

Le dispositif 10' comprend deux systèmes électroluminescents organiques 4a et 4b adjacents, chacun émetteur de lumière de préférence blanche ou, en variante par série de trois, de lumière rouge, verte et bleue. Les systèmes 4a et 4b sont connectés en série. L'électrode inférieure est divisée principalement en deux rectangles ou carrés 3a, 3b d'une dizaine de cm de coté chacun dépassant par un côté (gauche sur la figure). Ces zones d'électrodes sont séparées par la zone de gravure 310. La deuxième zone d'électrode 3b est séparée par la zone de gravure 320 d'une zone d'électrode inférieure « résiduelle » (à droite de la figure). La première section d'électrode inférieure 3a est recouverte partiellement par une première bande métallique formant « bus bar 61.

L'électrode supérieure est également divisée. La première section d'électrode supérieure 5a, dépasse vers le côté droit et recouvre le bord gauche de la deuxième section d'électrode inférieure 3b. La deuxième section d'électrode supérieure 5b dépasse vers le côté droit et recouvre le bord gauche de la section d'électrode inférieure résiduelle et est recouverte par une deuxième bande métallique formant « bus bar » 62.

Les zones de gravure 310, 320 sont par exemple des bandes de largeur de 20 à 50 µm pour être quasi invisibles à l'oeil nu.

Les figures 5 et 6 illustrent des vues schématiques de dessus montrant deux schémas de connexions électriques d'électrodes 20, 20' similaires à celles qui sont utilisées dans le deuxième mode de réalisation.

Dans la figure 5, trois systèmes électroluminescents organiques 4a à 4c sont connectés en série. Les zones de gravure 310 et 320 sont des bandes de largeur de 20 à 50 µm pour être quasi invisibles à l'oeil nu.

L'électrode inférieure est divisée en 3 rectangles d'une dizaine de cm de largeur chacun dépassant par un côté (gauche sur la figure). Ils sont séparés par les zones de gravure 310, 320. L'électrode supérieure 5a à 5c est également divisée en trois. La première section d'électrode inférieure est recouverte partiellement par une première bande métallique formant « bus bar 61.

Les deux premières sections d'électrode supérieure 5a, 5b dépassent vers le côté droit et recouvre le bord gauche de la section d'électrode inférieure adjacente. La troisième section d'électrode supérieure 5c, dépasse vers le côté droit et recouvre le bord gauche d'une section d'électrode inférieure résiduelle et est recouverte partiellement par une deuxième bande métallique formant « bus bar » 62.

Dans la figure 6, six systèmes électroluminescents organiques 4a à 4c, 4'a à 4'c sont connectés en série (trois en haut, trois en bas). Les zones de gravure 310 à 330 sont à la fois latérales 310, 320 et longitudinales 330, et sont des bandes de largeur de 20 à 50 µm pour être quasi invisibles à l'oeil nu.

L'électrode inférieure est divisée en six carrés d'une dizaine de cm de côté chacun dépassant par un côté (gauche sur la figure). Les sections d'électrode inférieure sont séparées par les zones de gravure 310 à 330'. La première bande formant bus bar est coupée pour former un collecteur de courant avec deux bandes 61', 62' du côté gauche de la figure.

L'électrode supérieure 5a à 5c, 5'a à 5'c est également divisée en six. Les deux premières sections hautes (en haut à gauche sur la figure) de l'électrode supérieure 5a à 5b dépassent vers le côté droit et recouvre le bord gauche de la troisième section de l'électrode inférieure adjacente.

La troisième section haute d'électrode supérieure 5b dépasse vers le côté droit et recouvre le bord gauche de la section d'électrode inférieure résiduelle et est recouverte par une bande métallique formant 610 d'interconnexion électrique avec la troisième section basse (en bas à droite sur la figure) d'électrode.

Les deux premières sections basses (en bas à gauche sur la figure) de l'électrode supérieure 5'a à 5'b dépassent vers le côté droit et recouvre le bord gauche de la troisième section basse de l'électrode inférieure adjacente.

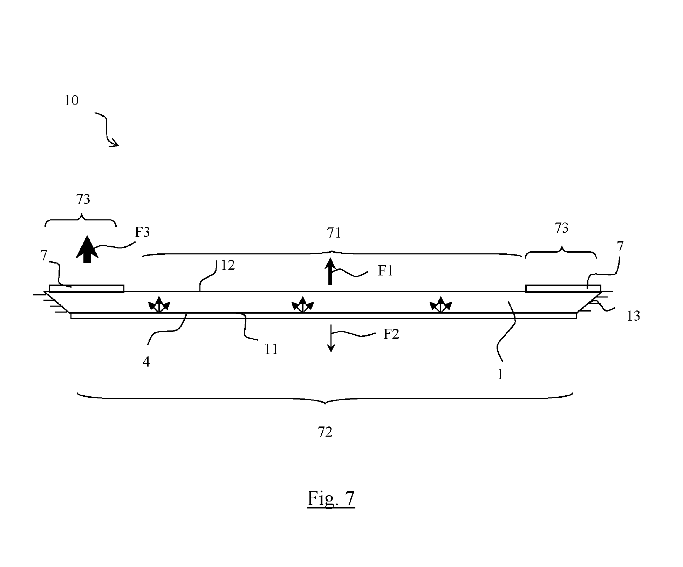

La figure 7 représente une vue schématique en coupe latérale d'un dispositif électroluminescent organique 10 utilisé pour un éclairage différencié.

Ce dispositif 10 comprend d'abord un substrat transparent plan, de préférence une feuille 1 en verre de préférence épaisse, par exemple de 4 ou 6 mm, et avec un coefficient d'absorption inférieur ou égal à 2,5 m⁻¹ dans le visible. On choisit de préférence un verre sodocalcique extraclair, de coefficient d'absorption inférieur à 0,7 m⁻¹ dans le visible. Ce verre 1 est doté de première et deuxième faces principales parallèles 12, 11 et d'une tranche 13. Le dispositif est refermé dans sa partie inférieure par un capot, non illustré ici.

Le dispositif électroluminescent 10 de type OLED inclut un système OLED 4 disposé sur une électrode inférieure de type ZnO:Al ₂₀ₙₘ/Ag _{12 nm}/Ti₁ₙₘ/ZnO:Al _{20 nm}/ITO _{20 nm} qui est sur une couche de fond en Si₃N₄ de 25 nm et agencée sur la première face principale 11. On définit des premières zones de lumière directe 71, 72 de part et d'autre du verre 1.

La première zone de lumière directe 71, du côté opposé au système OLED 4 par rapport au substrat 1, couvre la partie centrale de la première face principale 12. La deuxième zone de lumière directe 72, du côté du système OLED 4, s'étend sur toute la deuxième face principale 11.

On adapte les caractéristiques du dispositif 10 pour que la luminance L1 de la première zone de lumière directe 71 soit de préférence supérieure à la luminance L2 de la deuxième zone de lumière directe 72 (comme symbolisé par la flèche épaisse F1 et la flèche mince F2).

Pour avoir L1 supérieure à L2, le dispositif 10 est donc à émission principale par l'électrode inférieure. Par exemple on choisit L1 égale à environ 1000 cd/m² et L2 égale à environ 500 cd/m² pour un confort visuel.

Le dispositif 10 est aussi une source de rayonnement guidé dans l'épaisseur du verre 1, par réflexions totales. Le rayonnement guidé est extrait des bords de la première face 11 au moyen d'une couche diffusante 7 par exemple à base de particules diffusantes minérales dispersés dans un liant minéral. On définit ainsi une troisième zone de lumière 73 formant un cadre lumineux périphérique. En variante, la couche diffusante 7 forme uniquement des bandes latérales ou des bandes longitudinales périphériques.

Pour favoriser l'extraction du rayonnement guidé, chacun des bords formant la tranche 13 forme avec la deuxième face principale 11 associée à la source de lumière 10 un angle externe supérieur à 80° et comporte un miroir 14, par exemple une couche métallique argent ou cuivre.

Le dispositif 10 peut être destiné au bâtiment, être une fenêtre éclairante, une porte éclairante, une paroi de serre ou une verrière ou encore être une vitre latérale de véhicule ou un toit lumineux. La deuxième face 12 est la face intérieure (face la plus éclairante).

Lorsque le dispositif 10 est allumé, la zone de lumière directe 71 31 peut être apte à préserver l'intimité d'une personne à l'intérieur d'une pièce, d'un habitacle la nuit ou dans un environnement sombre. Il suffit pour cela que le flux lumineux envoyé par le vitrage soit au moins égal à celui réfléchi et renvoyé par la pièce.

Le dispositif 10 peut former un double vitrage, le dispositif 2 étant de préférence situé dans l'espace rempli de gaz interne entre le verre 1 et un verre additionnel éventuellement plus mince.

Le dispositif 10 ainsi conçu peut aussi servir d'étagère transparente et éclairante, de tablette lumineuse de réfrigérateur, de cloison transparente et éclairante entre deux pièces, de paroi d'un aquarium. On peut alors adapter les caractéristiques du dispositif 10 pour que la luminance L1 de la première zone de lumière directe 71 soit sensiblement égale à la luminance L2 de la deuxième zone de lumière directe 72.

Les zones de lumière 71, 72 sont uniformes. Le dispositif 10 peut aussi avoir, en variante, au moins une zone de lumière directe discontinue et/ou formant un dessin, un logo, une signalisation.

### FONCTIONS ADDITIONNELLES

Comme déjà dit, il peut être judicieux de fonctionnaliser la deuxième face du substrat 1 porteur (côté opposé au système électroluminescent organique).

On dépose ainsi à la surface des couches minces destinées à leur conférer une propriété particulière, comme par exemple celle qui consiste à permettre au substrat de rester le plus propre possible, quelles que soient les agressions environnementales, c'est-à-dire visant la permanence dans le temps des propriétés d'aspect et de surface, et permettant notamment d'espacer les nettoyages, en parvenant à éliminer au fur et à mesure les salissures se déposant progressivement à la surface du substrat, notamment les salissures d'origine organique comme les traces de doigts ou des produits organiques volatils présents dans l'atmosphère, ou même des salissures du type suie, poussières de pollution.

Or, on sait qu'il existe certains matériaux semi-conducteurs, à base d'oxyde métallique, qui sont aptes, sous l'effet d'un rayonnement de longueur d'onde adéquate, à initier des réactions radicalaires provoquant l'oxydation de produits organiques : on parle en général de matériaux « photo-catalytiques » ou encore « photo-réactifs ».

On connaît, dans le domaine des substrats à fonction de vitrage, l'utilisation de revêtements photo-catalytiques sur substrat, qui présentent un effet « anti-salissures » marqué et que l'on puisse fabriquer de manière industrielle. Ces revêtements photo-catalytiques comportent généralement de l'oxyde de titane au moins partiellement cristallisé, incorporé audit revêtement sous forme de particules, notamment de taille comprise entre quelques nanomètres (3 ou 4) et 100 nm, préférentiellement voisin de 50 nm pour l'essentiel cristallisées sous forme anatase ou anatase/rutile.

L'oxyde de titane fait en effet partie des semi-conducteurs qui, sous l'action de la lumière dans le domaine visible ou des ultraviolets, dégradent des produits organiques qui se déposent à leur surface.

Ainsi selon un premier exemple de réalisation, le revêtement à propriété photo-catalytique résulte d'une solution à base de nanoparticules de TiO₂ et d'un liant de silice (SiO₂ mésoporeuse.

Selon un deuxième exemple de réalisation, le revêtement à propriété photo-catalytique résulte d'une solution à base de nanoparticules de TiO₂ et d'un liant de silice (SiO₂) non structuré.

Quelle que soit la forme de réalisation du revêtement photo-catalytique, au niveau des particules d'oxyde de titane, le choix s'est porté, en outre, sur de l'oxyde de titane qui est au moins partiellement cristallisé parce qu'il a été montré qu'il était beaucoup plus performant en terme de propriété photo-catalytique que l'oxyde de titane amorphe. De préférence, il est cristallisé sous forme anatase, sous forme rutile ou sous forme d'un mélange d'anatase et de rutile.

La fabrication du revêtement est opérée de manière à ce que l'oxyde de titane cristallisé qu'il contient se trouve sous forme de « cristallites », c'est-à-dire de monocristaux, ayant une taille moyenne comprise entre 0,5 et 100 nm, de préférence 3 à 60 nm. C'est en effet dans cette gamme de dimension que l'oxyde de titane paraît avoir un effet photo-catalytique optimal, vraisemblablement parce que les cristallites de cette taille développent une surface active importante.

Le revêtement à propriété photo-catalytique peut comporter également, outre l'oxyde de titane, au moins un autre type de matériau minéral, notamment sous forme d'un oxyde amorphe ou partiellement cristallisé, par exemple en oxyde de silicium (ou mélange d'oxydes), de titane, d'étain, de zirconium ou d'aluminium. Ce matériau minéral peut aussi participer à l'effet photo-catalytique de l'oxyde de titane cristallisé, en présentant lui-même un certain effet photo-catalytique, même faible par rapport à celui du TiO₂ cristallisé, ce qui est le cas de l'oxyde de titane amorphe ou partiellement cristallisé.

On peut aussi augmenter le nombre de porteurs de charge par dopage du réseau cristallin de l'oxyde de titane, en y insérant au moins un des éléments métalliques suivants : niobium, tantale, fer, bismuth, cobalt, nickel, cuivre, ruthénium, cérium, molybdène.

Ce dopage peut aussi se faire par un dopage de surface seulement de l'oxyde de titane ou de l'ensemble du revêtement, dopage de surface réalisé en recouvrant au moins une partie du revêtement d'une couche d'oxydes ou de sels métalliques, le métal étant choisi parmi le fer, le cuivre, le ruthénium, le cérium, le molybdène, le vanadium et le bismuth.

Enfin, on peut amplifier le phénomène photo-catalytique en augmentant rendement et/ou cinétique des réactions photo-catalytiques, en recouvrant l'oxyde de titane ou au moins une partie du revêtement qui l'incorpore par un métal noble sous forme de couche mince du type platine, rhodium, argent.

Le revêtement à propriété photo-catalytique présente également une surface extérieure à caractère hydrophile et/ou oléophile prononcé, notamment dans le cas où le liant est minéral, ce qui amène deux avantages non négligeables : un caractère hydrophile permet un mouillage parfait de l'eau qui peut se déposer sur le revêtement, facilitant ainsi le nettoyage.

Conjointement à un caractère hydrophile, il peut aussi présenter un caractère oléophile, permettant le « mouillage » des salissures organiques qui, comme pour l'eau, tendent alors à se déposer sur le revêtement sous forme d'un film continu moins visible que des « taches » bien localisées. On obtient ainsi un effet « anti-salissures organiques » qui s'opère en deux temps : dès qu'elle se dépose sur le revêtement, la salissure est déjà peu visible. Ensuite, progressivement, elle disparaît par dégradation radicalaire amorcée par photocatalyse.

L'épaisseur du revêtement est variable, elle est comprise entre quelques nanomètres et quelques micromètres, typiquement comprise 50 nm et 10 µm.

En fait, le choix de l'épaisseur peut dépendre de différents paramètres, notamment de l'application envisagée du substrat, ou encore de la taille des cristallites de TiO₂ dans le revêtement. Le revêtement peut également être choisi de surface plus ou moins lisse : une faible rugosité de surface peut en effet être avantageuse, si elle permet de développer une surface photo-catalytique active plus grande. Cependant, trop prononcée, elle peut être pénalisante en favorisant l'incrustation, l'accumulation des salissures.

Selon une autre variante, la fonctionnalité qui est rapportée sur l'autre face du substrat peut être constituée par un revêtement anti-reflet.

Sont données ci-après les gammes préférées des épaisseurs géométriques et des indices des quatre couches de l'empilement antireflet, cet empilement étant dénommé A :
- n₁ et/ou n₃ sont compris entre 2,00 et 2,30, notamment entre 2,15 et 2,25, et préférentiellement voisin de 2,20.
- n₂ et/ou n₄ sont compris entre 1,35 et 1,65.
- e₁ est compris entre 5 et 50 nm, notamment entre 10 et 30 nm, ou entre 15 et 25 nm.
- e₂ est compris entre 5 et 50 nm, notamment inférieur ou égal à 35 nm ou à 30 nm, en étant notamment compris entre 10 et 35 nm.
- e₃ est compris entre 40 et 180 nm et préférentiellement entre 45 et 150 nm.
- e₄ est compris entre 45 et 110 nm et préférentiellement entre 70 et 105 nm.

Les matériaux les plus appropriés pour constituer la première et/ou la troisième couche de l'empilement A qui est de type antireflet, celles à haut indice, sont à base de nitrure mixte de silicium et de zirconium ou d'un mélange de ces nitrures mixtes. En variante, ces couches à haut indice sont à base de nitrures mixtes de silicium et de tantale ou d'un mélange de ces derniers. Tous ces matériaux peuvent être éventuellement dopés pour améliorer leurs propriétés de résistance chimique et/ou mécanique et/ou électrique.

Les matériaux les plus appropriés pour constituer la seconde et/ou la quatrième couche de l'empilement A, celles à bas indice, sont à base d'oxyde de silicium, d'oxynitrure et/ou d'oxycarbure de silicium ou encore à base d'un oxyde mixte de silicium et d'aluminium. Un tel oxyde mixte tend à avoir une meilleure durabilité, notamment chimique, que du SiO₂ pur (Un exemple en est donné dans le brevet EP 791 562). On peut ajuster la proportion respective des deux oxydes pour obtenir l'amélioration de durabilité escomptée sans trop augmenter l'indice de réfraction de la couche.

Une forme préférée de réalisation de cet empilement antireflet est de la forme substrat/ Si₃N₄/ SiO₂/ Si₃N₄/ SiO₂.

Il va de soi que l'invention s'applique de la même manière aux systèmes utilisant d'autres systèmes électroluminescents que ceux décrits dans les exemples.

## Revendications

1. Substrat (1), pour dispositif électroluminescent organique (10, 10'), porteur sur une première face principale (11) une électrode multicouche (3), dite inférieure, laquelle comporte successivement :
- une couche dite de contact (31) à base d'oxyde métallique et/ou de nitrure métallique,
- une couche fonctionnelle métallique (32) à propriétés intrinsèques de conductivité électrique, la couche fonctionnelle (32) est à base d'un matériau pur qui est de l'argent, ou à base dudit matériau allié ou dopé avec un autre matériau choisi parmi : Au, Pd, Al, Pt, Cu, Zn, Cd, In, Si, Zr, Mo, Ni, Cr, Mg, Mn, Co, Sn,
- un revêtement (33, 34) comportant une surcouche en matériau diélectrique à base d'oxyde métallique (34), formant une couche d'adaptation du travail de sortie, la surcouche étant la dernière couche,
**caractérisé en ce que** l'électrode multicouche (3) comprend en outre une fine couche de blocage (32') directement sur la couche fonctionnelle (32), la fine couche de blocage comprenant une couche métallique d'épaisseur inférieure ou égale à 5 nm et/ou une couche avec une épaisseur inférieure ou égale à 10 nm, qui est à base d'oxyde métallique sous stoechiométrique, d'oxynitrure métallique sous stoechiométrique ou de nitrure métallique sous stoechiométrique.

2. Substrat (1) selon la revendication 1 **caractérisé en ce que** la fine couche de blocage (32') est une couche métallique, nitrure et/ou oxyde métallique à base d'au moins l'un des métaux suivants : Ti, V, Mn, Fe, Co, Cu, Zn, Zr, Hf, Al, Nb, Ni, Cr, Mo, Ta, W, ou d'un alliage à base d'au moins un desdits matériaux et de préférence le niobium, le tantale, le titane, le chrome ou le nickel ou d'un alliage à partir d'au moins deux desdits métaux.

3. Substrat (1) selon l'une des revendications précédentes **caractérisé en ce que** la surcouche (34) est à base de l'un au moins des oxydes métalliques suivants :
- en oxyde conducteur éventuellement mixte et/ou dopé et/ou surstoechiométrique en surface choisi parmi l'oxyde d'indium, l'oxyde de zinc, l'oxyde d'étain, tel que l'oxyde d'étain dopé par Sb, ou l'oxyde de zinc dopé par Al, Ga, en étant éventuellement un oxyde mixte notamment oxyde mixte d'indium et d'étain, oxyde mixte d'indium et de zinc, oxyde mixte de zinc et d'étain,
- et/ou en oxyde sous stoechiométrique choisi parmi l'oxyde de molybdène, oxyde de nickel, oxyde d'aluminium, oxyde de titane, oxyde de zirconium, oxyde de tantale, oxyde de silicium, oxyde d'argent, d'or, de platine, de palladium, en éventuellement dopé et mixte, la surcouche en oxyde sous stoechiométrique étant de préférence d'épaisseur inférieure ou égale à 10 nm.

4. Substrat (1) selon l'une des revendications précédentes, **caractérisé en ce que** le revêtement (33, 34) comprend, entre la fine couche de blocage (32') et la surcouche (34), une couche de protection (33) contre l'eau et/ou l'oxygène à base de l'un au moins des oxydes métalliques suivants : oxyde d'indium, oxyde de zinc, oxyde d'étain, oxyde d'aluminium, oxyde de titane, oxyde de zirconium, oxyde de tantale, oxyde de silicium, cette couche étant éventuellement dopée, tel que l'oxyde d'étain dopé par Sb, ou l'oxyde de zinc dopé par Al, Ga, et/ou étant éventuellement un oxyde mixte notamment oxyde mixte d'indium et d'étain, oxyde mixte d'indium et de zinc, oxyde mixte de zinc et d'étain.

5. Substrat (1) selon l'une des revendications précédentes, **caractérisé en ce que** le revêtement (33, 34) est d'épaisseur supérieure ou égale à 20 nm et de préférence à base d'oxyde métallique.

6. Substrat (1) selon l'une des revendications précédentes, **caractérisé en ce que** la couche de contact (31) et la couche de protection contre l'eau et/ou l'oxygène (33) sont de nature identique, notamment à base de l'oxyde de zinc, éventuellement dopé par Al, et de préférence la surcouche (34) est de l'oxyde mixte d'étain et d'indium.

7. Substrat (1) selon l'une des revendications précédentes, **caractérisé en ce que** l'électrode (3) présente une transmission lumineuse T_{L} supérieure ou égale à 70% et une résistance carré inférieure ou égale à 10 Ω/carré pour une épaisseur de couche fonctionnelle à partir de 6 nm, de préférence inférieure ou égale à 5 Ω/carré pour une épaisseur de couche fonctionnelle à partir de 10 nm ou **en ce qu'**elle est présente une réflexion lumineuse R_{L} supérieure ou égale à 70% ou ce qu'elle présente une résistance carré inférieure ou égale à 3 Ω/carré pour une épaisseur de couche fonctionnelle à partir de 20 nm, de préférence inférieure ou égale à 1,8 Ω/carré, combinée de préférence un rapport T_{L} sur R_{L} entre 0,1 et 0,7.

8. Substrat (1) selon l'une des revendications précédentes, **caractérisé en ce que** l'épaisseur de la couche fonctionnelle (32) choisie à base d'argent est comprise entre 3 à 20 nm, préférentiellement comprise entre 5 à 15 nm ou **en ce que** l'épaisseur de la couche fonctionnelle choisie à base d'argent est comprise entre 20 à 50 nm ou **en ce que** l'épaisseur de la couche fonctionnelle choisie à base d'argent est comprise entre 50 et 150 nm, préférentiellement comprise entre 80 à 100 nm.

9. Substrat (1) selon l'une des revendications précédentes, **caractérisé en ce que** la couche de contact (31) est à base de l'un au moins des oxydes métalliques suivants : oxyde de chrome, oxyde d'indium, oxyde de zinc éventuellement sous stoechiométrique, oxyde d'aluminium, oxyde de titane, oxyde de molybdène, oxyde de zirconium, oxyde d'antimoine, oxyde d'étain, oxyde de tantale, oxyde de silicium, en étant éventuellement dopé, tel que l'oxyde d'étain dopé par F, Sb, ou l'oxyde de zinc dopé, en étant éventuellement un oxyde mixte notamment un oxyde mixte d'indium et d'étain, un oxyde mixte d'indium et de zinc, oxyde mixte de zinc et d'étain et **en ce que** la couche de contact est de préférence d'épaisseur entre 3 et 30 nm.

10. Substrat (1) selon l'une des revendications précédentes, **caractérisé en ce que** l'électrode comprend une fine couche de blocage dite inférieure, en contact direct avec la couche de contact et la couche fonctionnelle métallique et à base d'oxyde, de nitrure, d'oxynitrure métallique sous stoechiométrique avec une épaisseur inférieure ou égale à 10 nm et/ou une couche métallique d'épaisseur inférieure ou égale à 5 nm.

11. Substrat (1) selon l'une des revendications précédentes, **caractérisé en ce que** la première face principale (11) comporte, sous l'électrode (3), une couche de fond (2) susceptible de former une barrière aux alcalins, la couche de fond (2) est une couche, éventuellement dopée, choisie parmi une couche à base d'oxyde de silicium, d'oxycarbure de silicium, à base de nitrure de silicium, d'oxynitrure de silicium, d'oxycarbonitrure de silicium, de préférence d'épaisseur entre 10 et 150 nm.

12. Substrat (1) selon la revendication précédente **caractérisé en ce que** la première face principale (11) comprend une couche d'arrêt de gravure humide entre la couche de fond et la couche de contact, notamment une couche à base d'oxyde d'étain, ou **en ce qu'**une couche d'arrêt de gravure (2) fait partie ou forme la couche de fond, et de préférence est à base de nitrure de silicium ou est à base de d'oxyde de silicium ou d'oxycarbure de silicium avec de l'étain.

13. Substrat (1) selon l'une des revendications précédentes **caractérisé en ce que** sur les éventuelles couches de fond et/ou couche d'arrêt de gravure humide est agencé n fois la structure suivante, avec n un nombre entier supérieur ou égal à 1 : la couche de contact, éventuellement la fine couche de blocage inférieure, la couche fonctionnelle, la fine couche de blocage, éventuellement la couche de protection à l'eau et/ou à l'oxygène, la structure étant surmontée d'une séquence comprenant la couche de contact, la couche fonctionnelle, la fine couche de blocage, ledit revêtement comprenant éventuellement la couche de protection à l'eau et/ou à l'oxygène et comprenant ladite surcouche.

14. Substrat (1) selon l'une des revendications précédentes, **caractérisé en ce qu'**une bordure de la surcouche (34) est surmontée d'une bande métallique d'amenée de courant (61, 61', 62'), de préférence d'épaisseur comprise entre 0,5 à 10 µm et sous forme d'une monocouche en l'un des métaux suivants : Mo, Al, Cr, Nd ou en alliage tel que MoCr, AlNd ou d'une multicouche telle que MoCr/Al/MoCr.

15. Dispositif électroluminescent organique (10, 10') comportant au moins un substrat notamment verrier, avec une électrode inférieure selon l'une des revendications 1 à 14, comportant au moins une couche électroluminescente organique sur l'électrode inférieure et sous une électrode dite supérieure.
